# EUROPEAN PATENT APPLICATION

(11) **EP 0 871 027 A2**
(43) Date of publication of application: **14.10.1998**
(21) Application number: 98302680.8
(22) Date of filing: 06.04.1998
(51) Int. Cl.: G01N 21/88, G01R 31/309

(54) **Inspection of print circuit board assembly**

(30) Priority: 07.04.1997 US 834945; 17.02.1998 SG 9800343
(71) Applicant: Hewlett-Packard Company, Palo Alto, California 94304 (US)
(72) Inventor: Toh, Peng Seng, Singapore 609774 (SG)
(74) Representative: Powell, Stephen David

(57) **Abstract**

An apparatus for inspecting a Printed Circuit Board (PCB) comprises a plurality of obliquely-placed cameras (3-6) each having an optical axis oblique to the plane of the PCB assembly (1), the cameras being on the same side of the plane and approximately evenly distributed around an inspection area of the PCB assembly (1), a colour camera (2) on the same side of the plane as and substantially equidistant from the obliquely placed cameras, a light source (7) and a processor (60) for analysing the images from the obliquely placed cameras (3-6) to determine topographical defects in the PCB assembly (1) and for analysing the colour image from the colour camera (2) to determine electronic component defects in the PCB assembly (1). A method for inspecting a Printed Circuit Board (PCB) assembly (1) includes a multiple camera setup including frontal (2) and oblique (3-6) looking cameras to examine the Printed Circuit Board assembly (1) from different angles and a strong white light source (7) providing sufficient illumination, even at small camera aperture, to increase the depth of field.

## Description

This invention relates to a method and an apparatus for the inspection of Printed Circuit Board (PCB) assemblies by imaging with a machine.

Automated inspection of surface mount devices (SMDs) on printed circuit boards (PCBs) is becoming more important as electronics devices get smaller and packing density gets higher. Automated inspection has better performance than manual inspection in terms of consistency, speed and lower cost in the long run.

The commonly found defects on a surface mount PCB assembly include missing components, misalignment, titled components, tombstoning/open circuit, wrong components, wrong value, bridging/short circuit, bent leads, wrong polarity, extra components, lifted leads, insufficient solder, excessive solder among others.

An industrially useful inspection machine should be capable of detecting these defects reliably and fast enough to cope with the production rate. Broadly speaking, the inspection techniques can be divided into three different classes. These are the X-ray technique, laser scanning technique and machine vision technique. The X-ray technique consists of a fine focus X-ray source and appropriate detector to acquire and analyse X-ray images of the PCB assembly. Solder related defects such as insufficient solder, excessive solder, and poor wetting can be easily detected by the X-ray technique. However, wrong value, wrong components, wrong polarity, and bent leads cannot be detected using this method.

The laser scanning technique makes use of a laser triangulation method to determine the 3D profile of the PCB assembly. A laser beam is scanned across the surface of the PCB assembly and the returned beam information is used to calculate the 3D profile of the scanned path. The 3D profile of a PCB assembly is compared with that of a known good board. Wrong value, and polarity cannot be inspected using this method. A small deviation from this method is the utilisation of interference fringes created by the interference of two coherent laser beams on the surface of the PCB assembly.

The machine vision technique makes use of images captured by cameras or other video source for the analysis of the PCB assembly. This technique therefore relies heavily on the lighting and viewing setup. For example, one such technique uses a hemispherical lighting fixture containing hundreds of individually programmable LEDs which can be configured to achieve many combinations of lighting mode. Different solder or assembly defects are highlighted by different combinations of lighting mode. However, this method has certain limitations. For example, the light intensity generated by LEDs is usually not sufficiently bright and thus the camera aperture needs to be wide open. A large camera aperture will limit the depth of the field of the imaging system. The detection algorithms are closely related to the lighting mode and hence the selection and programming of the hundreds of LEDs is difficult. Hence, the teaching time required for a new PCB assembly is long and complicated.

Recently, a computer controlled, multiple angle illumination system for inspecting defects on PCBs has been described. The illumination system is computer controlled as to a level of intensity and adjustable as to angle of incidence. The illumination system includes illumination control electronics, a quad quartz halogen lamp array light source, a fibre optic line converter and an illumination collection system.

Many currently available inspection systems are not sufficiently reliable, accurate or immune to ambient conditions changes, and are complicated to set up for a new PCB assembly. Known inspection systems are difficult to operate for ordinary technicians or operators with minimum programming or machine vision knowledge.

The present invention discloses an improved method based on the use of a lighting and viewing technique.

According to an aspect of the present invention there is provided apparatus for inspecting a printed circuit board (PCB) assembly as specified in claim 1.

According to another aspect of the present invention there is provided a method for inspecting a printed circuit board (PCB) assembly as specified in claim 10.

Preferred embodiments include a plurality of cameras and a lighting assembly. The plurality of cameras includes a centre camera having an optical axis arranged substantially perpendicularly to the printed circuit board assembly and four surround cameras, the four surround cameras being arranged so that their respective optical axes are arranged obliquely with respect to the printed circuit board assembly and so that the optical axes of the four surround cameras are positioned symmetrically to the optical axis of the camera. Preferably, the centre camera is a colour camera and the surround cameras are monochrome cameras.

The four surround cameras are tilted at an angle with respect to the PCB assembly. The four monochrome cameras therefore acquire images of the PCB at an oblique angle. The plurality of images collectively provide an all round view of the PCB assembly allowing reliable and accurate analysis of the PCB assembly.

Preferred embodiments use a unique camera and lighting configuration to achieve a reliable inspection of the PCB assembly. In one embodiment, a multiple video camera system employing both monochrome and colour cameras (video source) is used. In the specification and claims, the term camera will be used when referring to a video camera.

Preferred methods involve illuminating the printed circuit board assembly using a lighting assembly, and viewing the printed circuit board assembly using a plurality of cameras. The plurality of cameras includes a centre camera having an optical axis arranged substantially perpendicularly to the printed circuit board assembly and four surround cameras. The four surround cameras are arranged so that their respective optical axes are arranged obliquely with respect to the printed circuit board assembly and so that the optical axes of the four surround camera are positioned symmetrically relative to said optical axis of the centre camera. A video signal from at least one of the plurality of cameras is forwarded to at least one frame grabber. The signal is then processed, whereby defects in the printed circuit board assembly can be detected.

Preferably, the images captured by the centre colour camera are subject to colour image processing to facilitate the extraction of the components from the background. For example, the PCB itself is mostly green in colour while the components are usually not.. In this way, acquiring colour images of the PCB assembly allows the components to be easily separated from its background.

Preferably. the four oblique monochrome cameras are positioned around the centre colour camera to view the PCB assembly from four different directions. For convenience, these directions are denoted by North, South, East and West. The field of view of the four oblique cameras are related to the centre colour camera such that a common area of the PCB assembly, hereinafter denoted as a segment, can be inspected at any one time by the cameras. Preferably, the field of views of any two opposite facing cameras do not overlap so that the image resolution and the total inspection area can be increased. Monochrome images can effectively capture the contrast between the solder or the leads and the PCB, but may not differentiate easily a component and the PCB. Mounting the four monochrome cameras obliquely with respect to the PCB assembly allows height information to be computed. The oblique monochrome cameras are hence effective when used to inspect lead geometry related defects such as lifted leads and bent leads.

Strong intensity lighting can be used such that the ambient lighting condition will not affect the actual inspection condition. Quantitatively, the light source should result in an intensity on the object at least ten times stronger than that due to the ambient lighting level. Strong lighting allows the aperture, also known as an iris, of the camera lens to be adjusted small, hence increasing the depth of field of the cameras. The size of the aperture is inversely related to the depth of field of an imaging system. A large depth of field renders the imaging systems less susceptible to the change in the height or depth of the object under inspection. The change in depth and height of the PCB assembly may arise from a change in components dimensions, the PCB thickness, or the warpage of the PCB. Such changes are undesirable and will affect the clarity of the images acquired by the cameras. Having a large depth of field enables well-focused images to be captured regardless of these variations. Furthermore, the monochrome cameras mounted at an oblique angle to the PCB assembly will need a large depth of field in order to view the entire field of view clearly. The near field and far field of an oblique viewing camera will have different depth. A white ring light source is preferably used. A white light source will allow different colour spectrum to be equally illuminated hence facilitating colour image processing and analysis. The use of a white light source with associated colour image processing is especially useful to detect colour components such as surface mounted resistors and capacitors. Some of these components may be brown, yellow, blue or orange in colour. If only monochrome images are used, then it will not be possible to distinguish the coloured components from the background. In monochrome images, the colour of the PCB and the coloured components may appear to have almost the same shade of grey, hence projecting no contrast to facilitate detection.

Preferably, the PCB assembly is placed
onto a X-Y table capable of moving the PCB assembly in the X and Y directions. A PCB assembly is usually larger than the field of the view of the cameras, hence the X-Y table is used to position the PCB assembly segment by segment under the camera and lighting assembly for inspection. In this way, the entire PCB assembly will be fully inspected. The size of the segment on the PCB assembly is determined by the field of view of the cameras. In particular, for defects that are to be detected by the centre colour camera, the segment size is determined by the field of view of the centre colour camera. For IC and other components that require lead inspection for lifted, bridging, bent leads, and solder defects on leads, the segment size will be determined by the field of the view of the four oblique monochrome cameras.

A rule-based approach for detecting defects on the PCB assembly can be used. Signatures are extracted from the plurality of images acquired by the colour and monochrome cameras. The signatures are verified with a set of rules to determine the condition of the PCB assembly.

Embodiments of the present invention will now be described, by way of example only, with reference to the accompanying drawings in which:
Fig.1 is a plan view of a preferred lighting and camera assembly;
Fig.2 is front view of the lighting and camera assembly;
Fig.3 is a field of view arrangement;
Fig.4 is an illustration of the depth of field for oblique view compensation;
Fig.5 is an illustration of the depth of field for warpage compensation;
Fig.6 is a block diagram of the overall system setup;
Fig.7 is a plan view of a quad flat pack IC with superimposed field of view of the four oblique monochrome cameras.
Fig.8 is a plan view of a small outline IC (SOIC) with superimposed field of view from two opposite-facing oblique monochrome cameras; and
Fig.9 is a front view of another embodiment of a lighting and camera assembly.

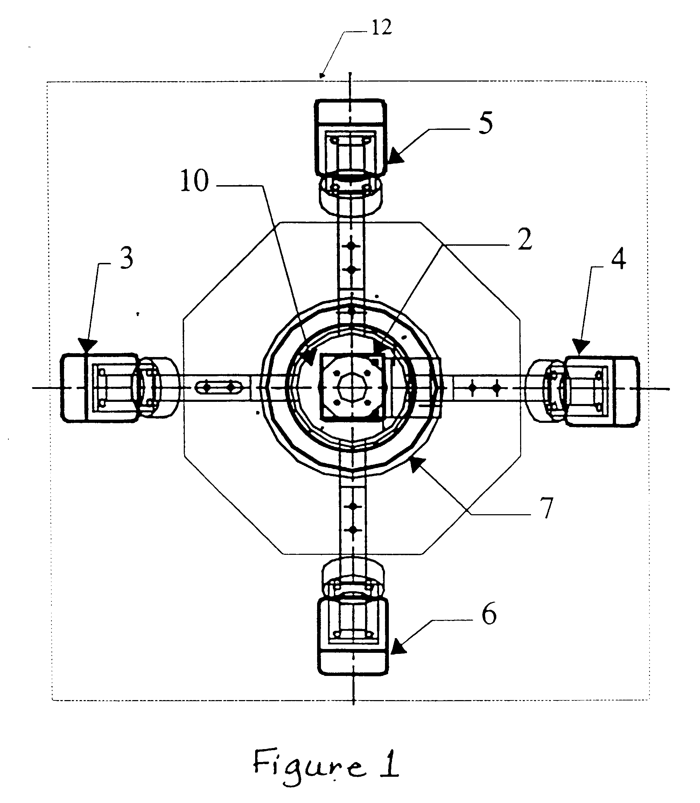

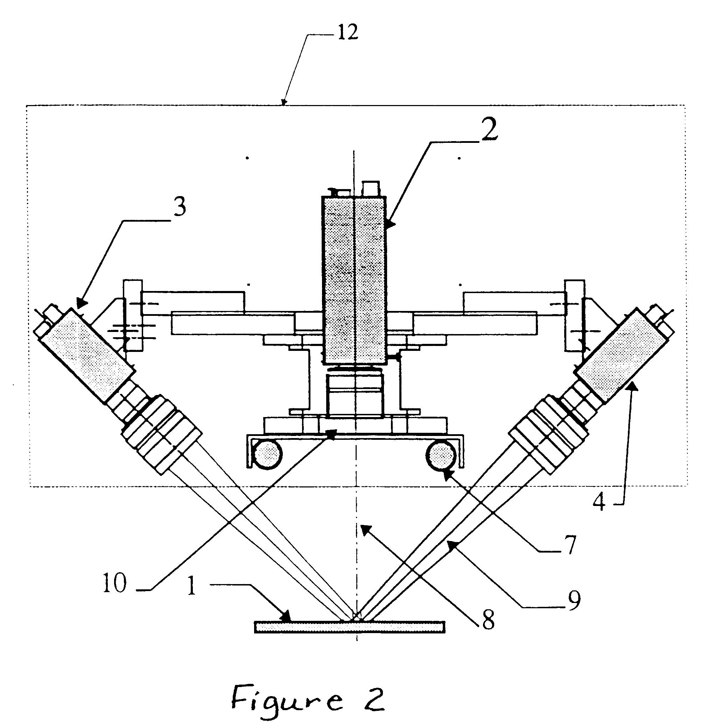

Referring to the drawings, Figure 1 shows an embodiment having five cameras 2,3,4,5 & 6. The centre camera 2 is a colour camera that views the PCB assembly 1 frontly i.e. at a normal. In other words, the optical axis 8 of the centre colour camera 2 is perpendicular to the PCB assembly 1. A bright white ring shape light source 7 is mounted below the centre colour camera 2 for illuminating the PCB assembly. The ring shape light source 7 has an opening 10 in its centre such that the centre colour camera 2 views the PCB assembly 1 through this opening 10. The four monochrome cameras 3,4,5 & 6 are positioned around the centre colour camera 2 symmetrically (i.e. spaced evenly). The optical axes of these monochrome cameras 3,4,5 & 6 are tilted at a certain angle with respect to the surface normal of the PCB assembly 1. In this embodiment, centre colour camera 2, four oblique monochrome cameras 3,4,5 & 6 and the white ring shape light source 7 are mounted on a common structure which is collectively called the camera and lighting assembly 12 (see Fig.2).

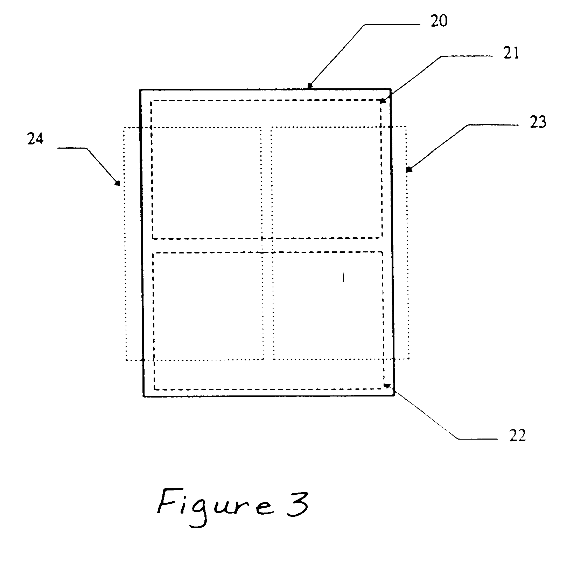

For convenience, the four oblique monochrome cameras are labelled as North 5, South 6, East 4 and West 3 respectively. The fields of view of any two opposite facing monochrome cameras do not overlap (see Figure 3). For example, the North 5 and South 6 cameras have no overlapping area. Their fields of view are denoted by first and second areas 21 and 22 respectively. Similarly, this applies to the East 3 and the West 4 cameras. Their fields of view are denoted by third and fourth areas 23 and 24 respectively. The separation between two opposite facing fields of view depends on the size of the IC used on the PCB assembly 1. The magnification factor of each of the four oblique monochrome cameras 3, 4, 5 & 6 are the same, thus enabling the same image processing algorithms to be applied to all of the four images.

The centre colour camera 2 is mainly responsible for the inspection of missing components, misalignment, tombstoning, bridging, wrong value of component, wrong components, wrong orientation or polarity, and solder related defects such as insufficient solder. The frontally looking centre colour camera does not induce any geometrical distortion in the imaging process. It is also not susceptible to obstruction by tall components.

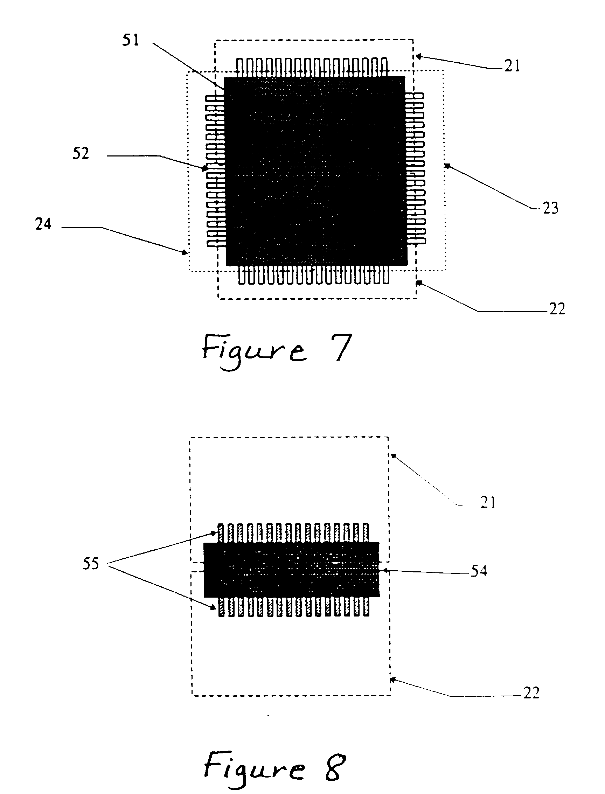

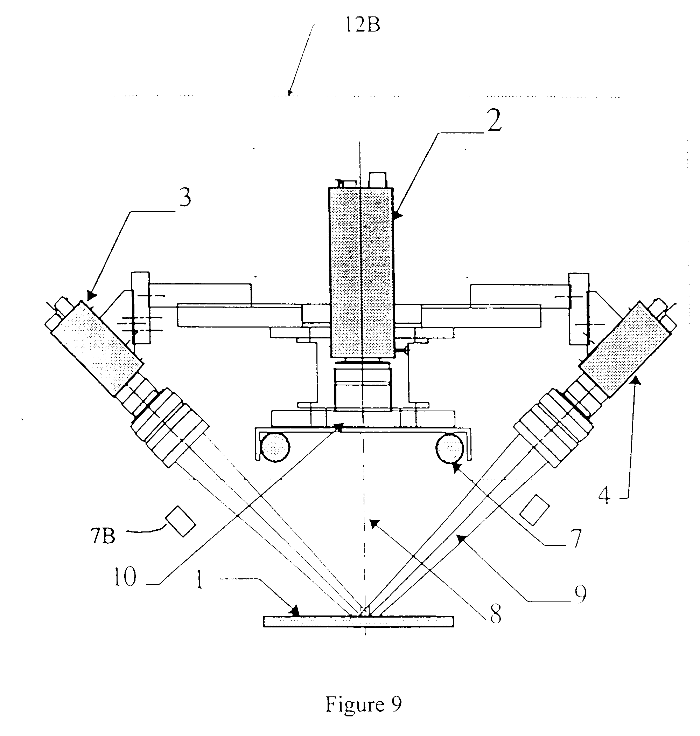

The four obliquely mounted monochrome cameras 3, 4, 5 & 6 are particularly suitable for the acquisition of images containing IC leads. For example, the leads 52 (see Figure 7) on the four sides of a quad flat pack IC 51 can be seen by the four monochrome cameras 3, 4, 5 & 6. The leads 52 on each side of the IC 51 is viewed by one of the four oblique monochrome cameras 3, 4, 5 & 6. In the case where an IC is larger than the field of view of the oblique monochrome cameras, several acquisition steps may have to be carried out to cover the leads 52 completely. Such a motion to acquire images on different areas can be accomplished by a X-Y table, which will be described in further detail below. For the case of dual sided IC such as the SOIC 54 (see Figure 8), only one pair of oblique monochrome cameras need to be used to view the leads 55. For example, if the SOIC 54 is mounted with its long side aligned in the East-West direction, then only the North 5 and the South 6 cameras are required to view the leads 55. As each of the four oblique monochrome cameras 3, 4, 5 & 6 are tilted with respect to the PCB assembly 1, height related information can be obtained. The variation in height of a component is translated as a shift in the position of the components. Lifted lead defect involves a change in the height of the lead and hence can be detected as a change in its position in the image captured by the oblique viewing cameras.

As shown in Figures I and 2, a white ring light source 7 is used in the present embodiment. The white ring light source 7 is mounted around the centre colour camera and illuminates the PCB assembly 1 from the top with uniform distribution of light. The white ring light source 7 has an opening 10 in its centre. The clear opening 10 enables the centre colour camera to view the PCB assembly 1 without obstruction. The white ring light source 7 enables different colours in the spectrum to be equally illuminated and hence facilitates colour image processing and analysis. The use of a white ring light source 7 with associated colour image processing is especially useful to detect coloured components such as surface mounted resistors and capacitors. Some of these components may be brown, yellow, blue or orange in colour. If only monochrome images are used, then it will not be possible to distinguish the coloured components from the background. In monochrome images, the colour of the PCB and the coloured components may appear to have almost the same shade of grey, hence projecting no contrast to facilitate detection.

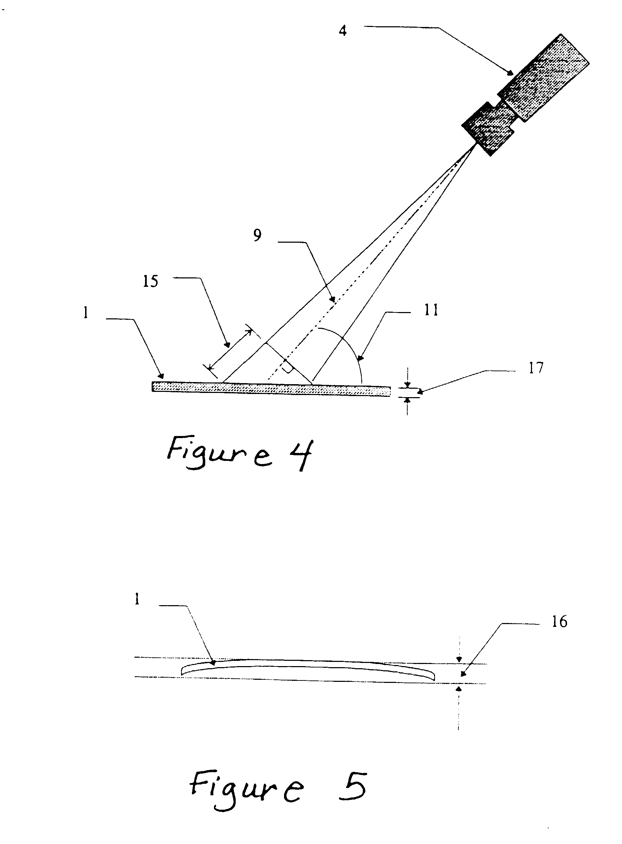

The white ring light source 7 has a strong intensity output such that the ambient lighting condition will not affect the actual inspection condition. Quantitatively, the white ring light source 7 intensity is more than ten times stronger than the ambient lighting level. Strong lighting intensity also allows the aperture, also known as an iris, of the cameras lens to be adjusted small, hence increasing the depth of field of the cameras. This is especially important for the four oblique monochrome cameras 3, 4, 5 & 6. The size of the aperture is inversely related to the depth of field of an imaging system. A large depth of field renders the imaging systems less susceptible to the change in the height or depth of the object under inspection. The change in depth and height of the PCB assembly 1 may arise from the change in components dimensions, the PCB thickness 17, and the warpage 16 of the PCB. These are undesirable changes and will affect the clarity of the images acquired by the cameras 2, 3, 4, 5 & 6. Having a large depth of field enables well focused images to be captured regardless of these variations. Furthermore, each of the monochrome cameras 3, 4, 5 & 6 mounted at an oblique angle 11 (see Figure 4) to the PCB assembly I need a large depth of field in order to view the entire field of view clearly. The near field and far field of an oblique viewing camera will have different depth as denoted by 15.

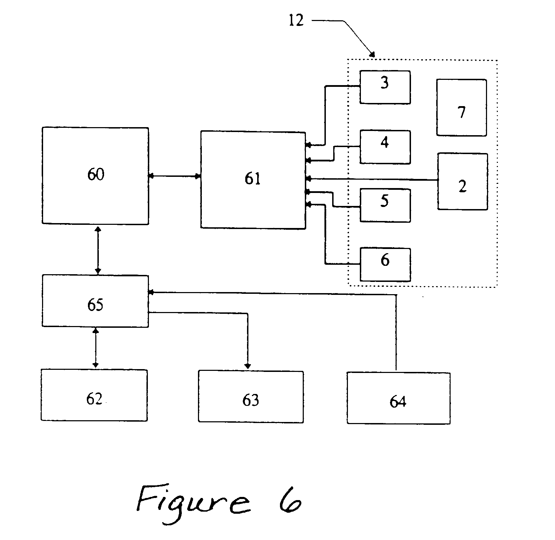

The size of the PCB assembly 1 may be much larger than the field of view of the cameras. Hence, in such a case, the PCB assembly 1 is divided into many different segments, one of which is inspected at a time. A X-Y table 62 (see Figure 6) is required to move each of the segments of the PCB assembly 1 to the camera and lighting assembly 12 (see Figure 2) for inspection. Each segment may include different components or ICs. The practical size of the field of view 20 (see Figure 3) of the centre colour camera 2 is determined by the smallest component size that can be found on a PCB assembly 1. Surface mounted components as small as 1.0 mm by 0.5 mm can be found. Hence the pixel resolution of 30-50 micron (10⁻⁶m) is required for the centre colour camera 2. The field of view is measured by the horizontal width (H) and vertical width (V). The horizontal factor of the field of view 20 is equal to the total number of pixels in the horizontal direction multiplied by the pixel resolution. Similarly, the vertical factor of the field of view is equal to the total number of pixels in the vertical direction multiplied by the pixel resolution. A pixel resolution of 20 - 30 micron is required for each of the oblique monochrome cameras 3, 4, 5 & 6. The effective field of view 21, 22, 23 & 24 of the oblique monochrome cameras 3, 4, 5 & 6 is smaller than that of the centre colour camera 20 (see Figure 3). Hence, there is a large overlap between the field of the view of the centre colour camera 2 and the four oblique monochrome cameras 3, 4, 5 & 6 as illustrated in Figure 3. The pixel resolution is a trade off between the speed of inspection and the accuracy of inspection. For example, if the pixel resolution is smaller than 20 micron, it will enable defects such as lifted lead to be detected with ease. However, if the field of view coverage is small and more X-Y stepping has to be carried out, an increase in the overall inspection time will result.

In the present embodiment, a rule based approach for detecting defects on the PCB assembly 1 is used. Signatures (i.e., specific information about each area) are extracted from the plurality of images acquired by the colour and monochrome cameras 2, 3, 4, 5 & 6. The signatures are verified with a set of rules for determining the condition of the PCB assembly 1. The rule-based approach means that there is no need to memorize the images of a known good PCB assembly 1. Hence reducing memory requirements in the image processing system and the computational speed. The signatures that can be extracted include the X and Y projections of the leads and body of the components and IC. Using the X and Y projections, several other parameters can be further extracted such as the number of transitions, the distance between the transitions, and the pitch between the transitions. These signatures are normalised so that they are less susceptible to changes in illumination conditions.

The overall system setup includes a personal computer (PC) which is used as the host 60. The PC host 60 is connected to frame grabbers 61 and programmable logic controller (PLC) 65. The PC host 60 coordinates the entire inspection activities. The frame grabbers 61 are further connected to the five cameras 2, 3, 4, 5 & 6. The frame grabbers 61 receive the video sources from the five cameras 2, 3, 4, 5 & 6 and digitize them in a form suitable for digital image processing. The frame grabbers 61 are equipped with image processors for digital image processing purposes. The PLC 65 receives inputs from a set of sensors 64. These sensors 64 are used to sense the presence of a PCB assembly on the conveyor 63, the home position and other safety features.The PLC 65 controls the X-Y table 62 which is responsible for moving the PCB assembly 1 segment by segment to the camera and lighting assembly 12 for inspection purposes.

Figure 9 shows yet another embodiment of a system of the present invention. As shown in Fig. 9, the present system 12B has all the features of the embodiment shown in Figure 2. Additionally, the system 12B has a second light source 7B (i.e.. in additional to light source 7) for illuminating the object 1 (e.g., PCB assembly) with a light of a wavelength that is distinguishable from the light from the light source 7. The light from the second light source 7B impinges on the object 1 at a substantial angle to the light from the light source 7 so that three dimensional features on the object 1 can appear differently under illumination by the light source 7 and illumination by light source 7B. The light source 7B can also have a ring shape to illuminate the object more evenly. Additional cameras can be used to capture the images of the wavelength of the second light source 7B. Alternatively, the same cameras 3, 4, etc. can be used if the light source 7 and 7B are used non-simultaneously. The information collected by the different cameras using different lights can be processed to analyse the three dimensional characteristics of the object 1.

The specifications of patent application numbers US08/834,945 and SG 9800343-7 and the abstract accompanying this application are incorporated herein by reference.

## Claims

1. Apparatus for inspecting a printed circuit board (PCB) assembly (I) comprising:
a plurality of obliquely-placed cameras (3-6) each having an optical axis oblique to the plane of the PCB assembly (1) for imaging electronic components of the PCB assembly, the obliquely-placed cameras (3-6) being on the same side of the plane and approximately evenly distributed around an inspection area of the PCB assembly (1);
a colour camera (2) on the same side of the plane as and substantially equidistant from the obliquely-placed cameras (3-6) for imaging electronic components of the PCB assembly (1) to determine colour and shapes of electronic components in the PCB assembly (1);
a light source (7) for illuminating the PCB assembly (1) to provide light for imaging in the cameras (2-6); and
a processor (60) for analysing the images from the obliquely-placed cameras (3-6) to determine topographical defects in the PCB assembly and for analysing the colour image from the colour camera (2) to determine electronic component defects in the PCB assembly.

2. Apparatus according to claim 1 wherein monochrome obliquely-placed cameras (3-6) are used.

3. Apparatus according to claim 1 or 2 wherein four obliquely-placed cameras (3-6) are used.

4. Apparatus according to claim 1,2 or 3 wherein video cameras are used as the cameras (2-6).

5. Apparatus according to any of claims 1 to 4 wherein the light source (7) is a white light source emitting light so as to result in light intensity more than ten times higher than ambient light level on the inspection area to provide large depth of field for topographical defect analysis.

6. Apparatus according to any of claims 1 to 5 wherein the light source (7) is a ring light source.

7. Apparatus according to any of claims 1 to 6 wherein the optical axis of the colour camera (2) is substantially perpendicular to the PCB assembly (1) and the optical axes of the obliquely-placed cameras (3-6) are substantially symmetrical relative to the optical axis of the colour camera (2).

8. Apparatus according to any of claims 1 to 7 wherein each camera has a field of view and the obliquely-placed cameras (3-6) are positioned such that the fields of view of two opposing obliquely-placed cameras (3,4; 5,6) positioned substantially symmetrically about the colour camera (2) do not substantially overlap.

9. Apparatus according to any of claims 1 to 8 wherein the cameras (2-6) are video cameras and the processor (60) compares the image information to a standard to determine defects on the PCB assembly (1), wherein a difference in height is processed in terms of a shift of position imaged by an oblique camera (3-6).

10. A method for inspecting a printed circuit board (PCB) assembly (1) comprising the steps of:
imaging obliquely electronic components on a surface of the PCB assembly (1) from one side of the plane to form oblique images from different perspectives around an inspection area of the PCB assembly (1);
imaging electronic components of the PCB assembly (1) to form colour image colour camera on the same side of the plane as the obliquely imaging, to determine colour and shapes of electronic components in the PCB assembly (1);
illuminating the PCB assembly (1) to provide light for imaging; and
analysing the oblique images to determine topographical defects in the PCB assembly (1) and analysing the colour image to determine electronic component defects in the PCB assembly (1).
